# EUROPEAN PATENT SPECIFICATION

(11) **EP 1 061 577 B1**
(45) Date of publication and mention of the grant of the patent: **24.10.2012**
(21) Application number: 00112296.9
(22) Date of filing: 08.06.2000
(51) Int. Cl.: H01L 23/538, H01L 23/498, H01L 23/50, H01L 23/66, H01L 23/552, H05K 9/00

(54) **High frequency multi-layered circuit component**
Hochfrequenzmehrlagenschaltungsbaustein
Dispositif de circuit multi couches à haute fréquence

(30) Priority: 17.06.1999 JP 17044799
(43) Date of publication of application: 20.12.2000
(73) Proprietor: MURATA MANUFACTURING CO., LTD., Nagaokakyo-shi, Kyoto 617-8555 (JP)
(72) Inventor: Shimada, Norihiro, Murata Manufacturing Co., Ltd., Nagaokakyo-shi, Kyoto-fu 617-8555 (JP); Ishii, Takehito, Murata Manufacturing Co., Ltd., Nagaokakyo-shi, Kyoto-fu 617-8555 (JP); Yoshimoto, Yoshihiro, Murata Manufac. Co., Ltd., Nagaokakyo-shi, Kyoto-fu 617-8555 (JP); Tonegawa, Ken, Murata Manufacturing Co., Ltd., Nagaokakyo-shi, Kyoto-fu 617-8555 (JP)
(74) Representative: Schoppe, Fritz

(56) References cited:
- WO-A-96/22008
- US-A- 5 483 413

## Description

### BACKGROUND OF THE INVENTION

### 1. Field of the Invention

The present invention relates to a high frequency multi-layered circuit component, more specifically, a high frequency multi-layered circuit component having active elements mounted thereon such as diodes, transistors, and ICs.

### 2. Description of the Related Art

A high frequency multi-layered circuit component is a composite component on which are mounted active elements such as diodes, transistors, and ICs as well as a plurality of passive circuit elements, for example, capacitors, inductors, and resistors distributed over a plurality of layers so that at least some of the plurality of circuit elements form a high frequency circuit. Such a high frequency multi-layered circuit component is provided with a power supply line for supplying direct-current power to the active elements, high frequency hot-lines included in the high frequency circuit, and ground layers.

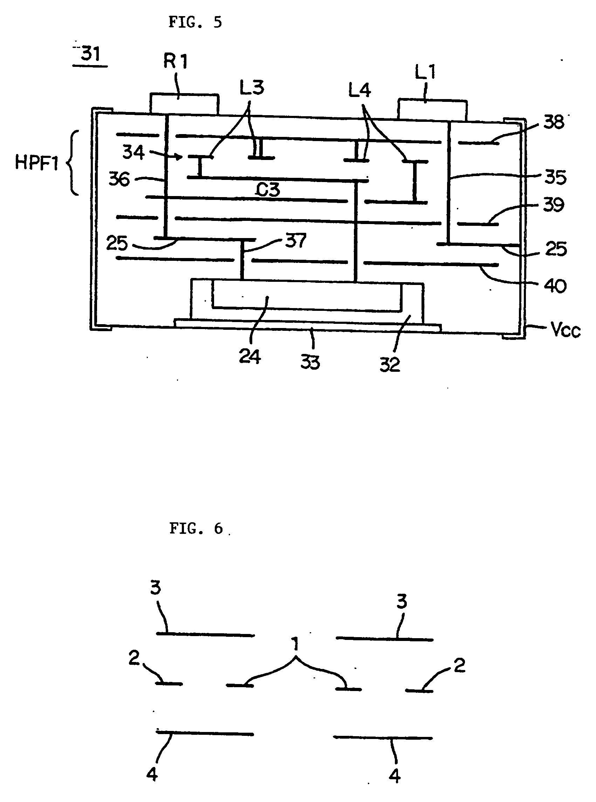

FIG. 6 schematically shows a typical example of the arrangement of the power supply line, high frequency hot-lines, and ground layers on a given cross-section of a conventional high frequency multi-layered circuit component.

As shown in FIG. 6, in most of the conventional high frequency multi-layered circuit components, the power supply line 1 and high frequency hot-line 2 are mounted along the same layer to make it compact, while the ground layers 3 and 4 are disposed so as to sandwich the power supply line 1 and high frequency hot-line 2 between them.

However, in the construction shown in FIG. 6, there is no conductor held at ground potential between the power supply line 1 and high frequency hot-line 2, to shield them from each other. Therefore, the power supply line 1 and high frequency hot-line 2 tend to readily affect each other.

As a result, alternating-current noise components due to high frequency signals flowing through the high frequency hot-line 2 can interfere with the direct-current power that is supplied to the active elements (not shown) via the power supply line 1. In that case, the bias voltage of the active elements tends to fluctuate, destabilizing the operation of the active elements. Also, since the power supply line 1 is disposed comparatively close to the high frequency hot-line 2, alternating-current noise components the power supply line 1 tend to adversely affect the high frequency hot-line 2.

WO 96/22008 A1 describes a low-EMI circuit which realizes a high mounting density by converting the potential fluctuation of a power supply layer with respect to a ground layer which occurs on switching an IC device etc., into Joule's heat in the substrate without using any parts as a countermeasure against the EMI. Parallel plate lines in which the Q-value of the stray capacitance between solid layers viewed from the power supply layer and ground layer is equivalently reduced and which are matchedly terminated by forming a structure in which a resistor (resistor layer) and another ground layer are provided in addition to the power supply layer and the ground layer on a multi-layered circuit board. A closed shield structure is also disclosed. Unwanted radiation is suppressed by absorbing the potential fluctuation (resonance) which occurs in a power supply loop by equivalently reducing the Q-value of the stray capacitance, absorbing the standing wave by the parallel plate lines matchedly terminated and, closing and shielding the parallel plate lines.

It is the object of the invention to provide a high frequency multi-layered circuit component in which interferences between a power line and a high frequency line, both inside the multi-layered circuit component, are reduced.

This object is achieved by a high frequency multi-layered circuit component according to claim 1.

In the above described high frequency multi-layered circuit component, a pair of said ground layers may be provided so as to sandwich the power supply line between them.

In the above described high frequency multi-layered circuit component, the pair of ground layers may be disposed with a narrow space between them so as to prevent high frequency signals from passing through the power supply line, by creating an impedance mismatch in the power supply line relative to the high frequency signals.

According to the above described structure and arrangement, it is possible to prevent the power supply line and the high frequency hot-lines from adversely affecting each other, since the power supply line for supplying direct-current power to the active element and the high frequency hot-lines included in the high frequency circuit are provided along mutually separated layers, and a ground layer is disposed between the power supply line and the high frequency hot-lines. The ground layer forms capacitance with the power supply line capacitance, thereby suppressing the alternating-current noise components, and preventing them from interfering with the direct-current power supplied through the power supply line. As a result, it is possible to advantageously prevent deterioration of operational stability due to the variations in the bias voltage of the active elements.

When the two ground layers are disposed so as to sandwich the power supply line between them, the above-mentioned effect may be obtained even more securely. With the pair of ground layers disposed to sandwich the power supply line between them, it is possible to even further suppress the alternating-current noise components flowing through the power supply line by producing a mismatch in the power supply line relative to the high frequency signals by making the space between two ground layers narrow, so as to prevent high frequency signals from passing through the power supply line.

Other features and advantages of the present invention will become apparent from the following description of an embodiment of the invention which refers to the accompanying drawings.

### BRIEF DESCRIPTION OF THE DRAWINGS

FIG. 1 is a perspective view schematically illustrating a part of a high frequency multi-layered circuit component 11 in an embodiment of the present invention.
FIG. 2 is a circuit diagram describing the effect of suppressing the alternating-current noise component flowing through the power supply line 15 shown in FIG. 1.
FIG. 3 is a perspective view schematically illustrating a part of a high frequency multi-layered circuit component 11a in another embodiment of the present invention.
FIG. 4 shows more specifically an example of a circuit 23 that can be constructed in a composite component using the high frequency multi-layered circuit component of the present invention.
FIG. 5 shows a cross-section of a high frequency multi-layered circuit component 31 for achieving the circuit 23 shown in FIG. 4.
FIG. 6 is an illustration schematically showing a typical example of the arrangement of a power supply line 1, a high frequency hot-line 2, and ground layers 3 and 4 on a specified cross-section of a conventional high frequency multi-layered circuit component of interest to the present invention.

### DESCRIPTION OF EMBODIMENTS OF THE INVENTION

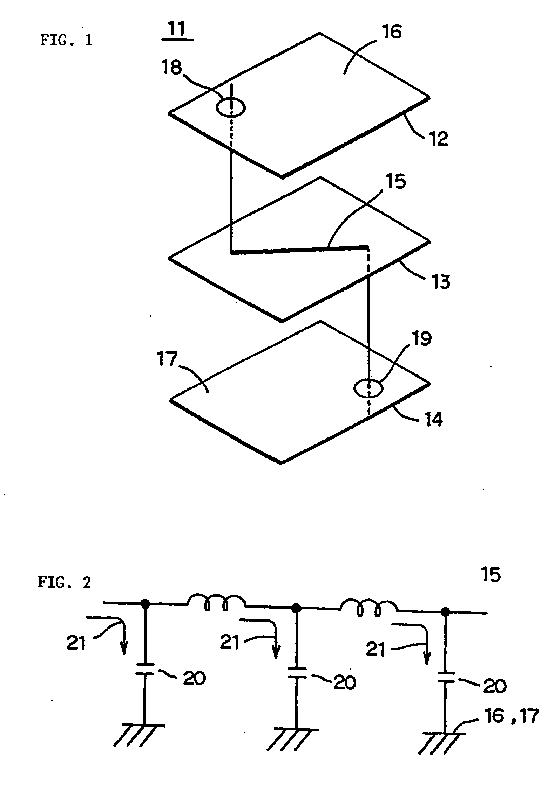

FIG. 1 is a perspective view schematically illustrating a part of a high frequency multi-layered circuit component 11 in an embodiment of the present invention.

In FIG. 1 are shown three dielectric layers 12, 13, and 14 made of ceramics, for example, mutually separated, forming a part of the high frequency multi-layered circuit component 11. Additional layers, not shown in Fig. 1, are disposed above the dielectric layer 12 and below the dielectric layer 14. (In this disclosure, the terms "above" and "below" and the like are merely relative terms and the structures described herein need not be oriented as shown in the drawings.)

Referring to the dielectric layers 12 to 14, the power supply line 15 is provided on the dielectric layer 13 positioned in the middle and the ground layers 16 and 17 are formed on the dielectric layers 12 and 14, respectively, so as to sandwich the power supply line between the layers. In the example of Fig. 1, the ground layers 16 and 17 are on top sides of the layers 12 and 14, respectively, and the power supply line 15 is correspondingly on the top side of the layer 13.

Also, a plurality of passive circuit elements (not shown) for forming a high frequency circuit are located on at least respective ones of the additional layers above the dielectric layer 12 and below the dielectric layer 14. The high frequency hot-lines included in the high frequency circuit (not shown) are also provided along those additional upper or lower dielectric layers, not shown. Active elements such as diodes, transistors, and ICs are also mounted on the additional dielectric layers, other than the dielectric layers 12 to 14 shown in the drawing.

An end of the power supply line 15 passes through a via-hole 18 to connect electrically to circuit elements or active elements located above the dielectric layer 12, while the other end of the power supply line 15 passes through a via-hole 19 to connect electrically to circuit elements or active elements located below the dielectric layer 14.

As described above, a construction is formed in which a power supply line 15 and high frequency hot-lines are provided along mutually separated layers and a situation is realized in which the ground layers 16 and/or 17 are disposed between the power supply line 15 and high frequency hot-lines. Also, the ground layers 16 and 17 are located adjacent to the power supply line 15.

FIG. 2 shows an equivalent circuit relating to the power supply line 15 in the arrangement shown in FIG. 1.

Now referring to FIG. 2, it is possible to form a capacitance between the power supply line 15 and the ground layers 16 and 17 by disposing the ground layers 16 and 17 adjacent to the power supply line 15 to form capacitance components 20 between the power supply line 15 and the ground layers 16 and 17. Accordingly, the alternating-current noise component on the power supply line can be reduced, since it can be diverted to the ground layers 16 and 17 through the capacitance component 20 as shown by arrows 21, so that the alternating-current noise component can be prevented from interfering with the direct-current power supplied through the power supply line 15.

Identically, it is desired to obtain a power supply line which only passes through the direct-current and cuts all the alternating-current components. The additional way to suppress the alternating-current components is to form the power supply line 15 to have an impedance mismatch relative to the high frequency signals. Basically, the line width of the power supply line 15 is widened or the spaces between the line and the two ground layers are narrowed to have the impedance mismatch. By this, the high frequency signals are further prevented from passing through the power supply line 15, and the alternating-current noise components are more effectively suppressed.

Also, an undesirable voltage drop in the power supply line 15 can be suppressed by providing the power supply line 15 with enough width to keep direct-current resistance in the power supply line 15 sufficiently low. To achieve this, the power supply line 15 should be more than 200 µm wide, for example.

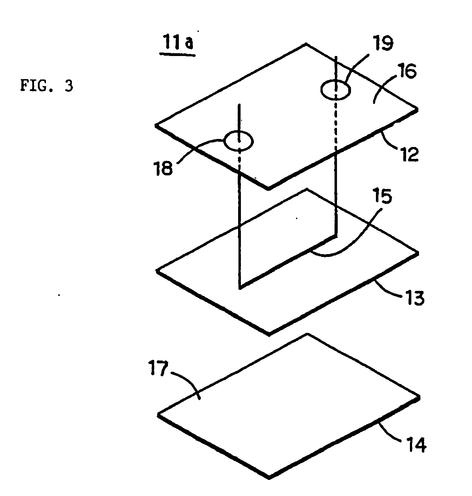

FIG. 3 is a perspective view schematically illustrating a part of the high frequency multi-layered circuit component 11a in another embodiment of the present invention. FIG. 3 is a view corresponding to FIG. 1 and the elements corresponding to those shown in FIG. 1 are referred to by the same numerals to omit duplicated descriptions.

In the high frequency multi-layered circuit component 11a shown in FIG. 3, the ends of the power supply line 15 pass through respective via-holes 18 and 19 to connect electrically to circuit elements and/or active elements located above the dielectric layer 12.

If, in FIG. 3, no high frequency hot-line is disposed below the dielectric layer 14, the ground layer 17 may be omitted.

As can be seen from the embodiments shown in FIGs. 1 and 3, the manner of routing of the power supply line within the high frequency multi-layered circuit component may be modified in various ways.

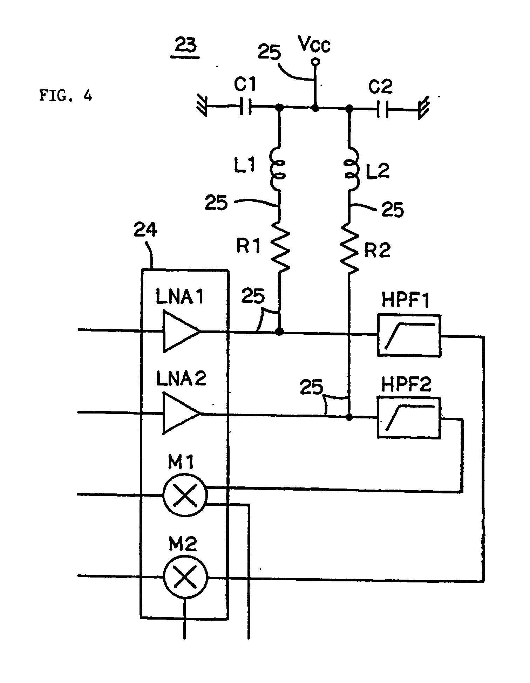

FIG. 4 shows more specifically an example of a circuit that can be constructed in a composite component including the high frequency multi-layered circuit component of the present invention. The composite component shown in FIG. 4 forms, for example, a receiving circuit in a mobile telephone.

More particularly, a composite component 23 comprises low-noise amplifiers LNA1 and LNA2 for amplifying signals received by a receiving antenna, not shown, high pass filters HPF1 and HPF2 for passing only signals with higher than specified frequencies out of the received signals amplified by the low-noise amplifiers LNA1 and LNA2, and mixers M1 and M2 for processing the outputs from the high pass filters HPF1 and HPF2. In this example, the amplifiers LNA1 and LNA2, and mixers M1 and M2 comprise an IC 24.

Also, the composite component 23 is provided with an external terminal Vcc and a power supply line 25 for supplying the direct-current power to IC 24 as an active element or, more specifically, to the amplifiers LNA1 and LNA2. The power supply line 25 has inductors L1 and L2, resistors R1 and R2, and capacitors C1 and C2.

The composite component 23, shown in FIG. 4 and described above, can be achieved by the high frequency multi-layered circuit component 31 shown in FIG. 5. FIG. 5 shows a cross-section of the high frequency multi-layered circuit component 31. Those skilled in the art will understand that FIG. 5 shows only one specific cross-section of the high frequency multi-layered circuit component 31 and not every circuit element shown in FIG. 4 can be or need be seen therein.

Referring to FIG. 5, a cavity 32 is provided in the bottom of the high frequency multi-layered circuit component 31 to contain the above-mentioned IC 24 here. The cavity 32 is closed by a lid 33.

Also, in the upper portion of the high frequency multi-layered circuit component 31 are shown inductors L3 and L4, and a capacitor C3, which together comprise HPF1 or one of the above-mentioned high-pass filters. The conductors providing such inductors L3 and L4, and capacitor C3 comprise the high frequency hot-line 34.

Also, the above-mentioned external terminal Vcc is provided on one of the end surfaces of the high frequency multi-layered circuit component 31. The above-mentioned power supply line 25 is conducted from the external terminal Vcc to the IC 24. The inductors L1 and L2, resistor R1, and capacitors C1 and C2 inserted therebetween are mounted on the top surface of the high frequency multi-layered circuit component 31 as discrete components. (Of those components, only the inductor L1 and resistor R1 are shown in FIG. 5.)

Now, the portion of the high frequency multi-layered circuit component 31 shown in FIG. 5 is described. The power supply line 25 extends along a certain layer from the connecting point with the external terminal Vcc. Then, it is conducted to the top surface of the high frequency multi-layered circuit component 31 through a via-hole connecting part 35. On the top surface the power supply line 25 is connected to the inductor L1 and resistor R1, etc., and then it is conducted again to the inside of the high frequency multi-layered circuit component 31 through a via-hole connecting part 36. It then extends along the same certain layer to be connected to the IC 24 through a via-hole connecting part 37.

Also, ground layers 38, 39, and 40 are provided within the high frequency multi-layered circuit component 31. Of the ground layers 38 to 40, the ground layer 39 is disposed between the power supply line 25 and the high frequency hot-line 34 and the ground layers 39 and 40 are disposed so as to sandwich the power supply line 25 between them.

Accordingly, the ground layers 39 and 40 form capacitance with the power supply line 25 so as to prevent an alternating-current noise component on the power supply line 25 from interfering with the direct-current power supplied through the power supply line 25.

Also, the ground layer 39 prevents undesirable interference between the power supply line 25 and the high frequency hot-line 34 so as to prevent any noise components flowing through the power supply line 25 from adversely affecting the high frequency hot-line 34 or the inductors L3 and L4, and capacitor C3, etc., even if the power supply line 25 is disposed adjacent to the high frequency hot-line 34.

While the invention has been particularly shown and described with reference to preferred embodiments thereof, it will be understood by those skilled in the art that the foregoing and other changes in form and details may be made therein without departing from the spirit of the invention.

## Claims

1. A high frequency multi-layered circuit component (31), comprising:
a plurality of layers (12, 13, 14) laminated to each other;
an active element (24) mounted on one of the plurality of layers (12, 13, 14);
a power supply line (25) disposed along one of the plurality of layers (12, 13, 14) for supplying a direct-current power to the active element (24);
high frequency signal-lines (34) included in the high frequency multi-layared circuit component and disposed along one or more of the plurality of layers (12, 13, 14) which are different from the one of the plurality of layers (12, 13, 14) along which the power supply line (25) is disposed;
a high frequency circuit (HPF1) comprising a capacitor (C3) and an inductor (L3, L4), said capacitor (C3) and said inductor (L3, L4) being formed by conductors which include a high frequency signel-line (34); and
a first ground layer (39) and a second ground layer (38) within the high frequency multi-layered circuit component which sandwich the high frequency circuit (HPF1) between them;
wherein said first ground layer (39) forms a capacitance with the power supply line (25) and is disposed for shielding between the power supply line (25) and the high frequency circuit (HPF1); and
wherein said second ground layer (38) is disposed between the high frequency circuit (HPF1) and discrete components (R1, L1) mounted on a top surface of the high frequency multi-layered circuit component.

2. The high frequency multi-layered circuit component (31) according to claim 1, further comprising a third ground layer (40), wherein said first and third ground layers (39, 40) sandwich said power supply line (25) between them.

## Patentansprüche

1. Eine Hochfrequenzmehrschichtschaltungskomponente (31), die folgende Merkmale aufweist:
eine Mehrzahl von Schichten (12, 13, 14), die aneinander laminiert sind;
ein aktives Element (24), das auf einer der Mehrzahl von Schichten (12, 13, 14) angebracht ist;
eine Leistungsversorgungsleitung (25), die entlang einer der Mehrzahl von Schichten (12, 13, 14) angeordnet ist zum Zuführen einer Gleichstromleistung an das aktive Element (24);
Hochfrequenzsignalleitungen (34), die in der Hochfrequenzmehrschichtschaltungskomponente enthalten sind und entlang einer oder mehreren der Mehrzahl von Schichten (12, 13, 14) angeordnet sind, die sich von der einen der Mehrzahl von Schichten (12, 13, 14) unterscheiden, entlang der die Leistungsversorgungsleitung (25) angeordnet ist;
eine Hochfrequenzschaltung (HPF1), die einen Kondensator (C3) und einen Induktor (L3, L4) aufweist, wobei der Kondensator (C3) und der Induktor (L3, L4) durch Leiter gebildet sind, die eine Hochfrequenzsignalleitung (34) umfassen; und
eine erste Masseschicht (39) und eine zweite Masseschicht (38) in der Hochfrequenzmehrschichtschaltungskomponente, zwischen denen die Hochfrequenzschaltung (HPF1) sandwichartig angeordnet ist;
wobei die erste Masseschicht (39) mit der Leistungsversorgungsleitung (25) eine Kapazität bildet und angeordnet ist zum Abschirmen zwischen der Leitungsversorgungsleitung (25) und der Hochfrequenzschaltung (HPF1); und
wobei die zweite Masseschicht (38) zwischen der Hochfrequenzschaltung (HPF1) und getrennten Komponenten (R1, L1) angeordnet ist, die auf einer oberen Oberfläche der Hochfrequenzmehrschichtschaltungskomponente befestigt sind.

2. Die Hochfrequenzmehrschichtschaltungskomponente (31) gemäß Anspruch 1, die ferner eine dritte Masseschicht (40) aufweist, wobei die Leistungsversorgungsleitung (25) zwischen der ersten und der dritten Masseschicht (39, 40) sandwichartig angeordnet ist.

## Revendications

1. Composant de circuit multicouche haute fréquence (31), comprenant :
une pluralité de couches (12, 13, 14) laminées les unes sur les autres ;
un élément actif (24) monté sur l'une de la pluralité de couches (12, 13, 14) ;
une ligne d'alimentation électrique (25) placée le long de l'une de la pluralité de couches (12, 13, 14) pour fournir une puissance DC à l'élément actif (24) ;
des lignes de signal haute fréquence (34), qui sont intégrées dans le composant de circuit multicouche haute fréquence et sont placées le long de l'une de la pluralité de couches ou plus (12, 13, 14) qui sont différentes de l'une de la pluralité de couches (12, 13, 14) le long de laquelle la ligne d'alimentation électrique (25) est placée ;
un circuit haute fréquence (HPF1) comprenant un condensateur (C3) et un inducteur (L3, L4), ledit condensateur (C3) et ledit inducteur (L3, L4) étant formés par des fils conducteurs qui comprennent une ligne de signal haute fréquence (34) ; et
une première couche de masse (39) et une deuxième couche de masse (38) à l'intérieur du composant de circuit multicouche haute fréquence, qui prennent le circuit haute fréquence (HPF1) en sandwich entre elles ;
dans lequel ladite première couche de masse (39) forme une capacitance avec la ligne d'alimentation électrique (25) et elle est placée de sorte à réaliser un blindage entre la ligne d'alimentation électrique (25) et le circuit haute fréquence (HPFL) ; et
dans lequel ladite deuxième couche de masse (38) est placée entre le circuit haute fréquence (HPF1) et des composants discrets (R1, L1) qui sont montés sur une surface supérieure du composant de circuit multicouche haute fréquence.

2. Composant de circuit multicouche haute fréquence (31) selon la revendication 1, comprenant par ailleurs une troisième couche de masse (40), dans lequel lesdites première et troisième couches de masse (39, 40) prennent ladite ligne d'alimentation électrique (25) en sandwich entre elles.
